(19) Europäisches Patentamt

European Patent Office

Office européen des brevets

(11) **EP 4 429 417 A1**

(12) **EUROPEAN PATENT APPLICATION**

(43) Date of publication:
**11.09.2024 Bulletin 2024/37**

(21) Application number: **23160473.7**

(22) Date of filing: **07.03.2023**

(51) International Patent Classification (IPC):
**H05K 3/34** (2006.01)    **H05K 3/12** (2006.01)

(52) Cooperative Patent Classification (CPC):
**H05K 3/3485;** H05K 3/1275; H05K 2203/0113;
H05K 2203/0338; H05K 2203/107

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Nederlandse Organisatie voor
toegepast-natuurwetenschappelijk Onderzoek
TNO
2595 DA 's-Gravenhage (NL)**

(72) Inventors:
• **ARUTINOV, Gari
2595 DA's-Gravenhage (NL)**
• **HENDRIKS, Rob Jacob
2595 DA's-Gravenhage (NL)**

(74) Representative: **V.O.
P.O. Box 87930
2508 DH Den Haag (NL)**

(54) **DEVICE AND METHOD FOR DEPOSITING A PRINTING MATERIAL ON A SUBSTRATE**

(57)    The invention is directed at a device (1) for depositing a printing material (16) on a substrate (5), the device comprising: an optically transmissive plate (2) comprising a first surface (3) and a second surface (4) opposite the first surface, wherein the first surface (3) provides an optical reception surface for receiving an optical radiation signal (10), and wherein the second surface (4) comprises at least one deposition cavity (15) configured for holding said printing material (16) prior to deposition thereof, wherein the first surface is configured for cooperating with an optical source (11) for receiving said optical radiation signal (10), and wherein the at least one deposition cavity (15) comprises one or more walls forming an interface between the at least one deposition cavity (15) and the transmissive plate (2), the one or more walls comprising a multilayer release stack (18), wherein the multilayer release stack comprises an optical absorption layer (25) and an impediment layer (26).

Fig. 2

EP 4 429 417 A1

## Description

Field of the invention

The present invention is directed at a device for depositing a printing material on a substrate, the device comprising: an optically transmissive plate comprising a first surface and a second surface opposite the first surface, wherein the first surface provides an optical reception surface for receiving an optical radiation signal, and wherein the second surface comprises at least one deposition cavity configured for holding said printing material prior to deposition thereof, wherein the first surface is configured for cooperating with an optical source for receiving said optical radiation signal. The invention is further directed at a method of depositing a dot of printing material on a substrate using a device as described above.

Background

High-throughput deposition of ultrafine (finer than 60 microns) dots and patterns of interconnect material (e.g. fine types of solder paste and conductive glues) is not possible with commercial printing technologies, such as stencil printing, dispensing and jetting. Instead, alternative methods may be applied in order to allow deposition of such materials in manufacturing processes, for research, or for other purposes.

One such alternative deposition method is provided by a deposition technique called laser induced forward transfer (LIFT). This technique applies an optical source, such as a laser, to print small fractions of material from a thin donor layer onto a receiving substrate. To do so, an optically transmissive plate (printing plate) comprises a surface provided with printing or deposition cavities. These cavities, for deposition, hold a printing material which is to be deposited on the substrate that is located underneath the optically transmissive plate. The opposite side or back side of the optically transmissive printing plate is selectively illuminated by an optical signal, e.g. a laser pulse. LIFT is based on the principle that the illuminated printing material in the cavity will heat-up and be propelled, as a result of gas production due to evaporation, from the cavity. To heat-up the printing material, an optical absorption layer may be present on the walls of the cavity, in order to take-up the optical radiation and convert it into heat.

Although the LIFT technique is a promising technology for enabling a larger range of printing materials to be deposited onto a substrate efficiently, control of the deposition technique is difficult for a variety of reasons. Therefore, the deposition results are not always satisfactory. For example, differences in the amount of heat conveyed to various parts of the cavity cause unpredictable evaporation in different parts of the cavity. As a result, a droplet of material may be released from the cavity, but the direction of release may be arbitrary.

Also, due to surface tension, the unpredictable and unequal evaporation causes the droplet to break-up, resulting in undesired printing results.

To overcome this problem, various improvements of the process have been proposed. For example, US20170268100 improvement is sought by relying on diffused light profile coming from a high-intensity flash lamp, with the intention to achieve uniform heat flux distribution within a cavity. However, here reflections of the incident light within the carrier plate fail to allow a sufficient level of homogenization of the incident heat profile. Furthermore, US20180171468 proposes to diffuse the incident light profile by introducing a diffusing pattern on the back side on the carrier. However, the diffusing of incident light is insufficient to achieve homogenization over the small dimensions of the cavities.

In WO2021201681, the application of a dichroic mirror prior to an absorber layer to achieve homogenized absorption of the incident profile within the cavity is more efficient to obtain desired results. However, this solution puts a number of challenging limitations on the design of the cavity to achieve a dichroic mirror effect. Firstly, each layer should be thinner than the wavelength of incident light (to avoid direct absorption effects) and at the same time should withstand thermal shock while the absorbing layer heats up. Secondly, the complex stack composition of the proposed dichroic mirror has to be modified and tailored to the angle and shape of the cavity, as it highly depends on the angle of the side walls.

Summary of the invention

It is an object of the present invention to provide for depositing of a printing material on a substrate, enabling the deposition of ultrafine dots, which is suitable for a large range of printing materials, and which provides for predictable and desirable printing results.

To this end, there is provided herewith a device for depositing a printing material on a substrate as described above, wherein the at least one deposition cavity comprises one or more walls forming an interface between the at least one deposition cavity and the transmissive plate, the one or more walls comprising a multilayer release stack, wherein the multilayer release stack comprises an optical absorption layer and a impediment layer, wherein the optical absorption layer is contiguous to the optically transmissive plate and is configured for converting optical energy from the optical radiation signal into a heat amount, and wherein the impediment layer is located between the optical absorption layer and an inside of the at least one deposition cavity, wherein the impediment layer comprises one or more thermal barrier layers, and wherein the optical absorption layer has a first thermal conductivity that is larger than a further thermal conductivity of the one or more thermal barrier layers, such as to enable lateral heat transfer within the optical absorption layer for homogeneously distributing the heat amount across the optical absorption layer during conduction of said heat amount through the impediment layer to the printing material in the at least one deposition cavity prior to deposition thereof.

In the device in accordance with the present invention, the impediment layer provides a thermal barrier that diminishes the direct heat transfer from the optical absorption layer to the printing material in the cavity. Because the optical absorption layer has a first thermal conductivity that is larger than the further thermal conductivities of the one or more thermal barrier layers that form the impediment layer, heat conducts more easily within the optical absorption layer. Therefore, if due to the illumination of the optical absorption layer, heat is distributed unequally across the optical absorption layer, heat is conducted more easily via lateral heat transfer through the optical absorption layer. Therefore, the impediment layer (or alternatively called "thermal impediment layer') impedes fast heat transfer to the printing material which thereby prevents an unequal distribution of heat in the printing material. The heat is first homogeneously distributed over the absorption layer, before the major part of the heat amount reaches the printing material. The printing is therefore better controlled, and the printing results are more predictable. This enables the deposition of ultrafine dots of a large range of printing materials, and provides predictable and desirable printing results.

In some embodiments, the optical source is a collimated optical source for receiving the optical radiation signal as a collimated optical radiation signal. The advantages of using a collimated optical source are to be found in the fact that the alignment of the optical signal results in a uniform distribution of optical radiation that is received on the receiving surface of the optical absorption layer, i.e. at the interface between the optically transmissive material of the optically transmissive plate and the optical absorption layer. As may be appreciated, if the optical radiation is collimated, differences in the amount of radiation received per surface area of the receiving surface of the optical absorption layer only exist if parts of the receiving surface have a distinguishing orientation (e.g. deviating from other parts of the receiving surface). Such parts of the surface may exist - as will be discussed later - dependent on the design of the deposition cavities.

In other or further embodiments, the device further comprises or is configured for cooperating with an optical source, wherein the optical source is a pulsed laser source for enabling the optical radiation signal to be received as an optical pulse of limited time duration. The use of a pulsed laser allows control over the process, such as to selectively illuminate e.g. each single deposition cavity of the optical transmissive plate. Moreover, the amount of optical radiation provided to each deposition cavity can be well controlled using a pulsed laser, e.g. by changing the pulse duration or duty cycle of the pulse, or by modifying the time dependent intensity profile of each pulse.

In yet further embodiments, the impediment layer has a second thermal conductivity, wherein the second thermal conductivity is determined by the further thermal conductivities of the one or more thermal barrier layers, and wherein the first thermal conductivity of the optical absorption layer is larger than the second thermal conductivity of the impediment layer. Referring to the invention as described above, this class of embodiments discriminates between the thermal conductivities of each thermal barrier layer - which are referred to as further thermal conductivities - and the thermal conductivity of the impediment layer - which is referred to as the second thermal conductivity. These two may be different for example when multiple thermal barrier layers together form the impediment layer, or when some parts of the impediment layer are made of thermal barrier layers of different material. For example, the side walls of the deposition cavities, which typically receive less optical radiation per surface area, may have an impediment layer being manufactured of different thermal barrier layers in order to either lower or raise the thermal conductivity. This allows to design with more control how heat is being conducted to the deposition cavity.

In some of these embodiments, the impediment layer has a thickness that is dependent on the first thermal conductivity and the second thermal conductivity for enabling said homogenizing of said heat amount. As may be appreciated, the balance of conducted heat amounts through the impedance layer or within the optical absorption layer depends not only on the thermal conductivities but also on the dimensions, such as the thicknesses, of these layers. Therefore, given a certain ratio between thermal conductivities as determined by the materials of choice for these layers, e.g. the first thermal conductivity with respect to the second thermal conductivity being in a certain ratio to each other, if a specific ratio of conducted heat amounts per unit of time is desired, this may be achieved by properly selecting the thicknesses of these layers in relation to each other. In this connection, again also the pulse duration and the time dependent intensity profile of the optical radiation will play a role in this. However, purely considering thermal conductivity and thickness, *per surface area* the amount of heat $q$ conducted by a material layer of thickness $l$, given its thermal conductivity $k_m$ and driven by a temperature difference of $\Delta T = T_2 - T_1$, will be:

$$ q = \frac{k_m \Delta T}{l} $$

Thus, where initial temperatures are known (or may be estimated), the preferred thicknesses may be calculated from the desired the desired initial heat flux ratio. Suppose, upon start of printing, the printing material in the deposition cavity is at room temperature (293k), then if the initial temperature differences across the optical absorption layer are determined or estimated (e.g.

based on the amount of optical radiation absorbed), the preferred thicknesses for achieving a heat flux ratio of 10:1 between the internal heat flux through the optical absorption layer $q_1$ and the heat flux through the impediment layer $q_2$ (i.e. the ratio $q_1:q_2$ is 10:1) can be calculated from this. Therefore, in a same manner in some further embodiments, the optical absorption layer has a thickness that is dependent on the first thermal conductivity and the second thermal conductivity for enabling said homogenizing of said heat amount.

In some embodiments, the impediment layer comprises a plurality of thermal barrier layers. Although a single, suitably selected thermal barrier layer is sufficient and often preferred for the impediment layer, it may be advantageous in some designs to apply two or more thermal barrier layers to achieve certain advantageous effects. For example, two thermal barrier layer with an additional thermal diffusion layer in between could potentially be applied to obtain a further redistribution of heat within the thermal diffusion layer.

In some of these embodiments, the second thermal conductivity of the impediment layer is provided by a composite thermal conductivity of the further thermal conductivities of the plurality of thermal barrier layers forming the impediment layer. From the thermal conductivities of each layer, a composite thermal conductivity or effective thermal conductivity may be determined for the impediment layer.

In some embodiments, the optical absorption layer is provided by a material layer of a first material, wherein the first material comprises at least one of a metal or an alloy. Preferably, the first material is a material having a very high thermal conductivity, while also being usable as an optical absorption layer. For example, the metal molybdenum (Mo) would be a good candidate or alloys thereof. Whereas in other or further embodiments, at least one of the one or more thermal barrier layers comprises, or is provided by, a material layer of a second material, wherein the second material comprises at least one of: a ceramic, a polymer, or a composite layer. For example, a ceramic such as silicon nitride (SiN) provides a good candidate. In accordance with a specific embodiment, at least one of the material absorption layer comprises a molybdenum chromium alloy; or at least one of the one or more thermal barrier layers comprises silicon nitride.

In accordance with a second aspect of the invention, there is provided a method of depositing a dot of printing material on a substrate using a device according to any one or more of the preceding claims, the device comprising an optically transmissive plate comprising a first surface and a second surface opposite the first surface, wherein the first surface provides an optical reception surface for receiving an optical radiation signal, and wherein the second surface comprises at least one deposition cavity configured for holding said printing material prior to deposition thereof, wherein the method comprises: filling the at least one deposition cavity with the printing material; and selectively illuminating at least a portion of the optical reception surface with the optical radiation signal, such as to convey the optical radiation signal via the transmissive plate to the at least one deposition cavity, for depositing the printing material onto the substrate; wherein the optical radiation signal is conveyed to the at least one deposition cavity through a multilayer release stack which comprises an optical absorption layer and a impediment layer, wherein the optical absorption layer converts optical energy from the optical radiation signal into a heat amount, and wherein the impediment layer diminishes conduction of the heat amount from the optical absorption layer to the at least one deposition cavity for enabling lateral heat transfer within the optical absorption layer for homogeneously distributing the heat amount across the optical absorption layer during conduction of said heat amount through the impediment layer to the printing material in the at least one deposition cavity prior to deposition thereof.

In some embodiments, the optical radiation signal is a collimated optical radiation signal. Furthermore, in some embodiments, the device further comprises or is configured for cooperating with an optical source, wherein the optical source is a pulsed laser source for enabling the optical radiation signal to be received as an optical pulse of limited time duration.

In other or further embodiments, of the device in accordance with the first aspect or the method in accordance with the second aspect, the printing material is at least one of: an interconnection material for use on the substrate, a solder paste, a glue, a resin, an ink, or a polymer.

Brief description of the drawings

The invention will further be elucidated by description of some specific embodiments thereof, making reference to the attached drawings. The detailed description provides examples of possible implementations of the invention, but is not to be regarded as describing the only embodiments falling under the scope. The scope of the invention is defined in the claims, and the description is to be regarded as illustrative without being restrictive on the invention. In the drawings:

Figure 1 schematically illustrates a device in accordance with an embodiment of the present invention;
Figure 2 schematically illustrates an enlarged view of a deposition cavity in a device in accordance with an embodiment of the present invention;
Figures 3A to 3D schematically illustrate a deposition process in accordance with an embodiment, applying a device in accordance with an embodiment of the invention;
Figures 4A and 4B illustrate deposition problems experienced due to inhomogeneous cavity temperatures;
Figures 5A and 5B provide a comparison of the printing results obtainable with an inventive printing process as compared to the results in absence of a multilayer release stack as proposed.

Detailed description

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

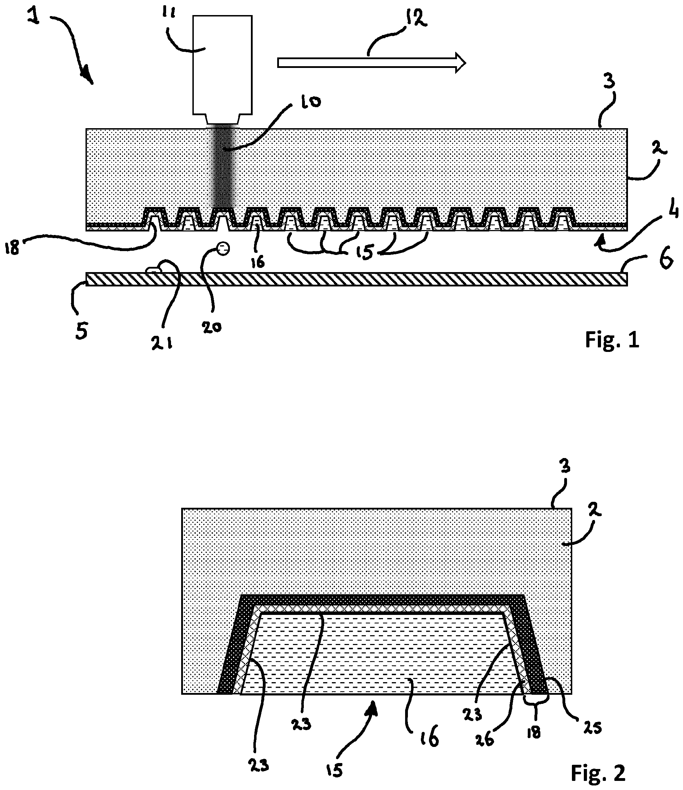

Figure 1 illustrates a device or arrangement 1 in accordance with an embodiment of the present invention. The device 1 is suitable for depositing a printing material 16 on a substrate 5. In fact, the device 1 enables to deposit portions 21 of printing material 16 on the surface 6 of the substrate 5. The printing material 16 is deposited by the formation of droplets 20 that are propelled from deposition cavities 15 that are filled with the printing material 16 prior to release thereof. The device 1 is suitable for and may be used to perform laser induced forward transfer (LIFT) of the printing material 16.

The device 1 comprises an optically transmissive plate 2. The optically transmissive plate 2 may be made of an optically transmissive material, such as quartz or another type of transmissive crystal or mineral, a type of glass, a transmissive polymer, a transmissive resin or any other transmissive material providing suitable optical and thermodynamic properties. In terms of the latter, the material of which the optically transmissive plate 2 is made preferably transmits an optical radiation signal 10, with which it may be illuminated, effectively in order to convey the majority thereof and prevent the formation of heat in the optically transmissive plate 2 as much as possible. The optically transmissive plate 2 comprises a first surface 3 and a second surface 4 opposite the first surface 3. The first surface 3 provides an optical reception surface for receiving an optical radiation signal 10 from an optical source 11. The second surface 4 comprises one or more, and preferably a plurality of deposition cavities 15. The deposition cavities 15 are configured for holding the printing material 16 prior to deposition. Preferably, a plurality of deposition cavities 15 in a regular arrangement is present on the second surface 4 of the optically transmissive plate 2. For example, the regular arrangement may form a matrix of pixels or another regular arrangement of pixels. The printing or deposition of printing material 16 may then be performed by selectively illuminating such pixels, for example under the control of a controller (not shown) or control system (not shown).

The first surface 3 is configured for cooperating with the optical source 11 for receiving the optical radiation signal 10. In figure 1, the optical source 11 moves in the direction indicated by arrow 12 relative to the optically transmissive plate 2. As may be appreciated, also the plate 2 may be moved while keeping the optical source 11 stationary, or even both the optically transmissive plate 2 and the optical source 11 may be moved to provide a relative motion as indicated by the arrow 12 in figure 1. The optical source 11 moves over each deposition cavity 15 and selectively illuminates the cavities 15 by means of the optical radiation signal 10. Upon illuminating the cavity 15, the printing material will be released therefrom forming a droplet 20, and deposited as a printed portion 21 on the surface 6 of the substrate 5.

The optical radiation signal 10 may be provided by the optical source 11 as a continuous signal which is temporarily blocked, e.g. by an optical obstruction such as a shutter or similar, there where deposition cavities 15 do not need to be illuminated (because they are not selected for illumination). The optical obstruction could be moved away for illuminating a cavity 15 selectively. Alternatively, the optical source may be triggered selectively to fire the optical radiation signal 10 as an optical pulse. The pulse may contain sufficient optical energy (desirably distributed in time) to trigger the deposition of the printing material 16 from the cavity 15. As a further alternative, the optical radiation signal 10 provided by the optical source 11 may be a pulsed laser beam formed of a (continuous or discontinuous) pulse train, where the pulses may be selectively blocked or transmitted. This may for example be achieved by using an optical obstruction, such as a controllable shutter, or by switching the source on and off selectively.

With reference to figure 2, for depositing, the deposition cavities 15 comprise walls 23 that are covered with a multilayer release stack 18. Each cavity 15 of the deposition cavities 15 comprises one or more walls 23 forming an interface between the deposition cavity 15 and the optically transmissive plate 2. The walls 23 comprising the multilayer release stack 18. The multilayer release stack 18 comprises an optical absorption layer 25 and an impediment layer 26. The optical absorption layer 25 is contiguous to the optically transmissive plate 2 and is configured for converting optical energy from the optical radiation signal 10 into heat, such as to aggregate a heat amount. The optical absorption layer 25 may for example be made of a material that effectively converts the an optical signal, at the optical wavelengths comprised by the signal, into heat. Therefor, the choice of materials for the optical absorption layer 25 may be (although this is optional) tuned to the optical radiation signal 10 provided by the optical source 11. As will be appreciated, some materials are known to be perfect absorbers for a large range of optical wavelengths, in which case it may not be necessary to tune the choice of material for the optical absorption layer 25 to the optical radiation signal 10 of the optical source 11. Furthermore, as will be explained further below, the material of which the optical absorption layer 25 is made is selected to be a good thermal conductor.

The impediment layer 26 is located between the optical absorption layer 25 and an inside of the deposition cavity 15. The main task of the impediment layer 26 is to delay heat transfer between the optical absorption layer 25 and the printing material 16 in the deposition cavity 15. Although this may sound counterproductive, in fact this provides an important advantage to the device 1 of the present invention. Due this function of the impediment layer 26, heat conduction between the optical absorption layer 25 and the printing material 16 is slowed down, leaving more time available for obtaining a homogeneous distribution of heat in the optical absorption layer 25. The impediment layer 26 therefore comprises one or more thermal barrier layers. In the most common approach, and in accordance with an important class of embodiments, the impediment layer 26 comprises only a single thermal barrier layer which thus forms the impediment layer 26. However, it is certainly possible to provide an impediment layer 26 having multiple layers of different materials or a series of materials in order to obtain a specific advantageous effect. In connection with each other, the optical absorption layer 25 has a first thermal conductivity that is larger than a further thermal conductivity of the (one or more) thermal barrier layers that form the impediment layer 26. Heat will then be conducted more easily within the optical absorption layer 25 then through the impediment layer 26. As a result, lateral heat transfer within the optical absorption layer 26 is obtained which results in a homogeneous distribution of the heat amount across the optical absorption layer 25. Because at the same time the heat amount is also (more slowly) conducted through the impediment layer 26 to the printing material 16 in the deposition cavity 15, effectively a homogeneous distribution of heat across all walls 23 (and every portion thereof) is obtained prior to deposition of the printing material 16.

In figure 1, the multilayer release stack 18 is applied as a set of layers covering the whole of (or majority of) the second surface 4 of the optically transmissive plate 2. This is allowed in accordance with a certain class of embodiments. However in some other or further embodiments, the multilayer release stack 18 is only present inside the cavities 15, for example as is illustrated in figure 2. In this latter case, heat conduction towards a neighboring cavity 15 via the optical absorption layer 25 is prevented more effectively, leading to a more efficient transfer of heat to the illuminated cavity 15.

Good candidates for use as material for the optical absorption layer 25 are for example metals or metal alloys, such as molybdenum (Mo) or alloys of molybdenum. For example, in some embodiments, the optical absorption layer 25 was made of a molybdenum chromium (MoCr) alloy. Other metals or alloys thereof may likewise be applied, such as iron, aluminum, or any other metal. The impediment layer 26 may be made of a thermal insulator or dielectric, for example silicon nitride (SiN) or some polymer or resin. Furthermore, also the dimensions of the layer may be selected in the design of device 1. For example, the optical absorption layer 25 may be ten times as thick as the impediment layer 26. In an embodiment, an optical absorption layer 25 made of molybdenum chromium (MoCr) was used having a thickness of 500 nm (nanometers), with an impediment layer 26 made of silicon nitride (SiN) having a thickness of 50 nm. The thickness of each layer may be tuned to the other relevant parameters in order to obtain, within each layer 25 and 26 and given a certain temperature difference, a desired amount of heat conduction in relation to the heat conduction in the other layers. The initial temperatures within each layer 25 and 26 and the printing material 16, as well as within various parts of the optical absorption layer 25 and the impediment layer 26 may be estimated. From this, a desired initial magnitude of heat transfer within and between al layers may be determined based on the thermal conductivity of each layer 25, 26 and the printing material 16. The temporal distribution of optical energy may also play a role in this, and can even be used to optimize the deposition process. This altogether may result in a preferred thickness of each layer, and therefore it is not really possible to indicate a preferred thickness range for each layer (this depends on the thermal and optical properties of the other layers). Therefore, without being limiting on the invention, a rough estimate of thickness ranges may at best be provided here. For the optical absorption layer 25, this may be less than 2 micrometer (less then 2000 nm). For the impediment layer 26, at least some thickness is desired, say between 30 nm and 1000 nm. The layers may be coated on the walls, or deposited thereon using a layer deposition technique (e.g. atomic layer deposition (ALD) or chemical vapour deposition (CVD)). To prevent the multilayer release stack 18 to be present between the deposition cavities 15, a selective removal technique may be used such as etching or grinding. The depth of the cavities 15 may be in the order of micrometers, tens of micrometers, or hundreds of micrometers. Preferably, the corners of the walls 23 forming the deposition cavities 15 may be rounded or curved, as this may benefit the flow of heat.

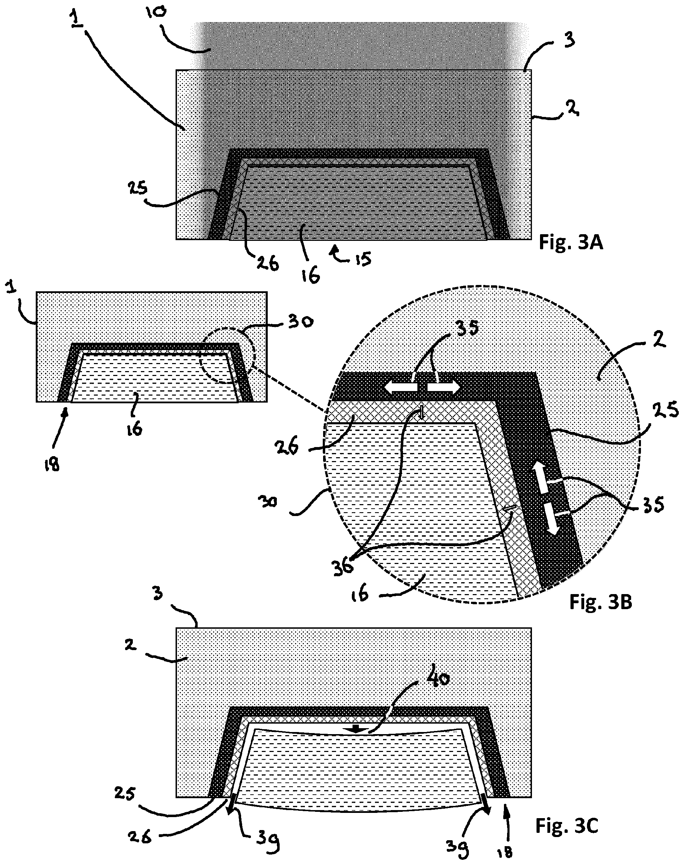

Figures 3A to 3D illustrate the working principle of the present invention. In figure 3A it is illustrated that an optical radiation signal 10 illuminated a cavity 15. In the cavity, a printing material 16 is present, which is applied to the cavity 15 prior to the start of the deposition method or between two subsequent printing steps. The optical radiation signal 10 preferably illuminates the whole optical absorption layer 25 that surrounds the cavity 15 covering its walls 23. Preferably, the optical radiation signal is a collimated optical signal, such that the beam energies are uniformly distributed across the beams cross-section. However, even though in this case, optical energy is received everywhere in the optical absorption layer 25, it is not received everywhere equally. Clearly, the side walls of the cavity are under a different angle with the beam providing the optical radiation signal 10, as compared to the top wall 23 (which is transverse to the beam). Thus, the top wall 23 received the highest amount of optical radiation energy per surface area, whereas less optical energy per surface area received by the side walls is much less due to the oblique angle of receipt. After fully absorbing an optical pulse, for example, the side walls 23 therefore remain colder than the top walls 23.

In figure 3B, the functioning of the impediment layer 26 is illustrated. An enlargement of a part of the deposition cavity walls 23 is illustrated in the circle 30. Due to the lower thermal conductivity of the impediment layer 26, the heat flow 35 within the optical absorption layer 25, stimulated by the temperature differences between the various parts of the walls 23, is maximized. Heat thus quickly redistributes within the optical absorption layer 25 before it is conveyed through the impediment layer 26. While the temperature differences within the optical absorption layer 25 equal out, and the heat distribution becomes more homogeneous, the heat flow 35 within the optical absorption layer 25 diminishes, unit heat is only conveyed by the heat flow 36 through the impediment layer 26 to the printing material 16 in the deposition cavity 15.

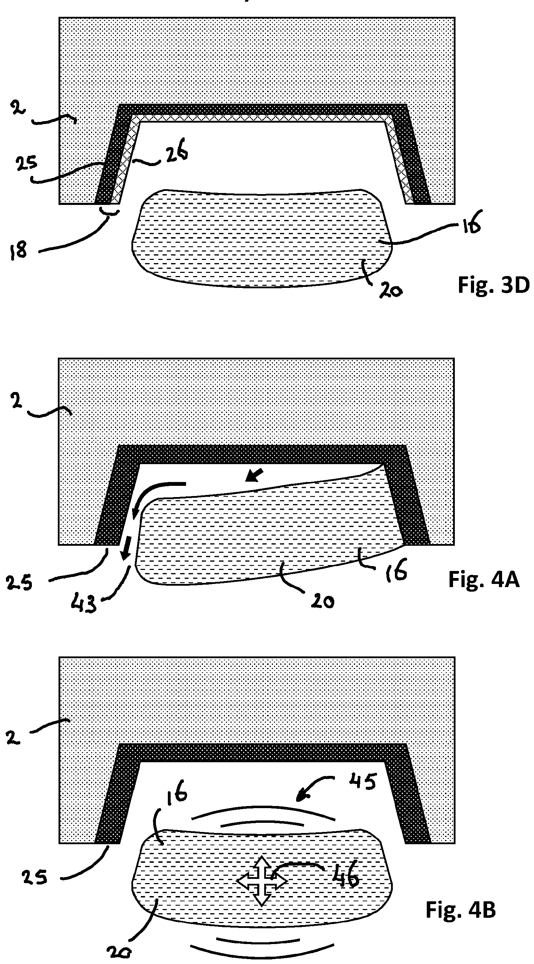

Figure 3C shows that the printing material 16 directly contiguous to the walls 23 starts to evaporate. The vapourized printing material 16 escapes partly via the circumference of the pocket of printing material 16, as illustrated by flow arrows 39. However, the pressure build-up illustrated by arrow 40 propels the pocket of printing material 16 from the deposition cavity 15 downwards. Figure 3D show this process, where the printing material 16 starts to form a droplet 20 while accelerating to the substrate surface 6.

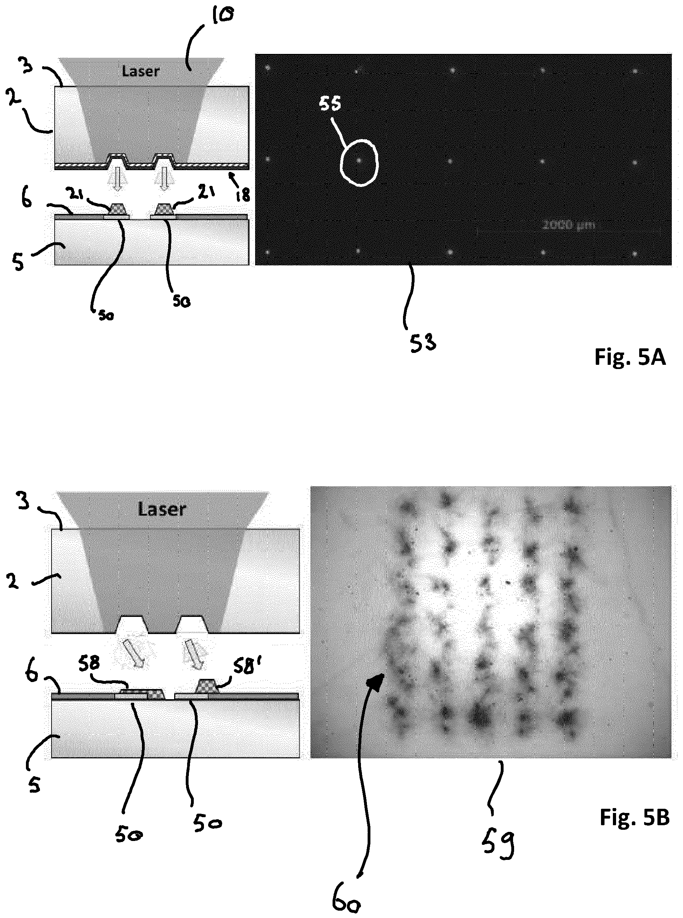

Figures 4A and 4B show what may happen in absence of the impediment layer 26, leading to suboptimal or bad printing quality experienced with other (LIFT) deposition techniques. In figure 4A, the lower temperature of the side walls 23 cause the printing material 16 to come loose over only a part of the side wall 23. This results in an oblique propulsion of the droplet 20. The portion of printing material 16 will in that case not be incident on the targeted location on the substrate surface 6. In figure 5A, an inhomogeneous pressure distribution in the droplet will cause the droplet 20 to start vibrating (see 45 and 46). This likewise may cause a tilted release and other undesired printing effects.

Results of the deposition method of the present invention are illustrated in figures 5A and 5B. Figure 5A shows the results of the deposition method of the present invention. Clear and sharp printed portions 55 at very regular distances can be seen in the figure. A comparative test was performed with a device without the multilayer release stack 18 of the present invention. Clearly, the printing material 16 is exploded across the surface, and no clear printing portions can be distinguished.

The present invention has been described in terms of some specific embodiments thereof. It will be appreciated that the embodiments shown in the drawings and described herein are intended for illustrated purposes only and are not by any manner or means intended to be restrictive on the invention. It is believed that the operation and construction of the present invention will be apparent from the foregoing description and drawings appended thereto. It will be clear to the skilled person that the invention is not limited to any embodiment herein described and that modifications are possible which should be considered within the scope of the appended claims. Also kinematic inversions are considered inherently disclosed and to be within the scope of the invention. Moreover, any of the components and elements of the various embodiments disclosed may be combined or may be incorporated in other embodiments where considered necessary, desired or preferred, without departing from the scope of the invention as defined in the claims.

In the claims, any reference signs shall not be construed as limiting the claim. The term 'comprising' and 'including' when used in this description or the appended claims should not be construed in an exclusive or exhaustive sense but rather in an inclusive sense. Thus the expression 'comprising' as used herein does not exclude the presence of other elements or steps in addition to those listed in any claim. Expressions such as "consisting of', when used in this description or the appended claims, should be construed not as an exhaustive enumeration but rather in an inclusive sense of "at least consisting of'. Furthermore, the words 'a' and 'an' shall not be construed as limited to 'only one', but instead are used to mean 'at least one', and do not exclude a plurality. Features that are not specifically or explicitly described or claimed may be additionally included in the structure of the invention within its scope. Any of the claimed or disclosed devices or portions thereof may be combined together or separated into further portions unless specifically stated otherwise, without departing from the claimed invention. Expressions such as: "means for ..." should be read as: "component configured for ..." or "member constructed to ..." and should be construed to include equivalents for the structures disclosed. The use of expressions like: "critical", "preferred", "especially preferred" etc. is not intended to limit the invention. Additions, deletions, and modifications within the purview of the skilled person may generally be made without departing from the spirit and scope of the invention, as is determined by the claims. The invention may be practiced otherwise then as specifically described herein, and is only limited by the appended claims.

**Claims**

1. Device for depositing a printing material on a substrate, the device comprising:

   an optically transmissive plate comprising a first surface and a second surface opposite the first surface, wherein the first surface provides an optical reception surface for receiving an optical radiation signal, and wherein the second surface comprises at least one deposition cavity configured for holding said printing material prior to deposition thereof, wherein the first surface is configured for cooperating with an optical source for receiving said optical radiation signal, and
   wherein the at least one deposition cavity comprises one or more walls forming an interface between the at least one deposition cavity and the transmissive plate, the one or more walls comprising a multilayer release stack,
   wherein the multilayer release stack comprises an optical absorption layer and a impediment layer, wherein the optical absorption layer is contiguous to the optically transmissive plate and is configured for converting optical energy from the optical radiation signal into a heat amount, and wherein the impediment layer is located between the optical absorption layer and an inside of the at least one deposition cavity, wherein the impediment layer comprises one or more thermal barrier layers, and wherein the optical absorption layer has a first thermal conductivity that is larger than a further thermal conductivity the one or more thermal barrier layers, such as to enable lateral heat transfer within the optical absorption layer for homogeneously distributing the heat amount across the optical absorption layer during conduction of said heat amount through the impediment layer to the printing material in the at least one deposition cavity prior to deposition thereof.

2. Device according to claim 1, wherein the optical source is a collimated optical source for receiving the optical radiation signal as a collimated optical radiation signal.

3. Device according to claim 1 or 2, wherein the device further comprises or is configured for cooperating with an optical source, wherein the optical source is a pulsed laser source for enabling the optical radiation signal to be received as an optical pulse of limited time duration.

4. Device according to any one or more of the preceding claims, wherein the impediment layer has a second thermal conductivity, wherein the second thermal conductivity is determined by the further thermal conductivities of the one or more thermal barrier layers, and wherein the first thermal conductivity of the optical absorption layer is larger than the second thermal conductivity of the impediment layer.

5. Device according to claim 4, wherein the impediment layer has a thickness that is dependent on the first thermal conductivity and the second thermal conductivity for enabling said homogenizing of said heat amount.

6. Device according to claim 4 or 5, wherein the optical absorption layer has a thickness that is dependent on the first thermal conductivity and the second thermal conductivity for enabling said homogenizing of said heat amount.

7. Device according to any one or more of the preceding claims, wherein the impediment layer comprises a plurality of thermal barrier layers.

8. Device according to claim 7, wherein the second thermal conductivity of the impediment layer is provided by a composite thermal conductivity of the further thermal conductivities of the plurality of thermal barrier layers forming the impediment layer.

9. Device according to any one or more of the preceding claims, wherein the optical absorption layer is provided by a material layer of a first material, wherein the first material comprises at least one of a metal or an alloy.

10. Device according to any one or more of the preceding claims, wherein at least one of the one or more thermal barrier layers comprises, or is provided by, a material layer of a second material, wherein the second material comprises at least one of: a ceramic, a polymer, or a composite layer.

**11.** Device according to any one or more of the preceding claims, wherein at least one of:

the material absorption layer comprises a molybdenum chromium alloy; or
at least one of the one por more thermal barrier layers comprises silicon nitride.

**12.** Method of depositing a dot of printing material on a substrate using a device according to any one or more of the preceding claims, the device comprising an optically transmissive plate comprising a first surface and a second surface opposite the first surface, wherein the first surface provides an optical reception surface for receiving an optical radiation signal, and wherein the second surface comprises at least one deposition cavity configured for holding said printing material prior to deposition thereof, wherein the method comprises:

filling the at least one deposition cavity with the printing material; and
selectively illuminating at least a portion of the optical reception surface with the optical radiation signal, such as to convey the optical radiation signal via the transmissive plate to the at least one deposition cavity, for depositing the printing material onto the substrate;

wherein the optical radiation signal is conveyed to the at least one deposition cavity through a multilayer release stack which comprises an optical absorption layer and a impediment layer, wherein the optical absorption layer converts optical energy from the optical radiation signal into a heat amount, and wherein the impediment layer diminishes conduction of the heat amount from the optical absorption layer to the at least one deposition cavity for enabling lateral heat transfer within the optical absorption layer for homogeneously distributing the heat amount across the optical absorption layer during conduction of said heat amount through the impediment layer to the printing material in the at least one deposition cavity prior to deposition thereof.

**13.** Method according to claim 12, wherein the optical radiation signal is a collimated optical radiation signal.

**14.** Device according to claim 12 or 13, wherein the device further comprises or is configured for cooperating with an optical source, wherein the optical source is a pulsed laser source for enabling the optical radiation signal to be received as an optical pulse of limited time duration.

**15.** Method according to any one or more of claims 12-14, wherein the printing material is at least one of: an interconnection material for use on the substrate, a solder paste, a glue, a resin, an ink, or a polymer.

**Fig. 1**

**Fig. 2**

Fig. 3A

Fig. 3B

Fig. 3C

Fig. 3D

Fig. 4A

Fig. 4B

Fig. 5A

Fig. 5B

Europäisches
Patentamt

European
Patent Office

Office européen
des brevets

**EUROPEAN SEARCH REPORT**

Application Number

EP 23 16 0473

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 2017/268100 A1 (HENDRIKS ROB JACOB [NL] ET AL) 21 September 2017 (2017-09-21) * paragraphs [0007], [0014] – [0027], [0034] – [0037]; claims 1-19; figures 1-3 * ----- | 1-15 | INV. H05K3/34 H05K3/12 |
| X,D | WO 2021/201681 A1 (TNO [NL]) 7 October 2021 (2021-10-07) * page 13, lines 17-27; claims 1-15; figure 6 * ----- | 1-15 | |

TECHNICAL FIELDS
SEARCHED        (IPC)

H05K
C03C
C23C

The present search report has been drawn up for all claims

| Place of search | Date of completion of the search | Examiner |
|---|---|---|
| The Hague | 7 August 2023 | Bacon, Alan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 23 16 0473**

This annex lists the patent family members relating to the patent documents cited in the above-mentioned European search report.
The members are as contained in the European Patent Office EDP file on
The European Patent Office is in no way liable for these particulars which are merely given for the purpose of information.

**07-08-2023**

| Patent document cited in search report | | Publication date | Patent family member(s) | | Publication date |
|---|---|---|---|---|---|
| US 2017268100 | A1 | 21-09-2017 | US 2017268100 | A1 | 21-09-2017 |
| | | | US 2017275750 | A1 | 28-09-2017 |
| WO 2021201681 | A1 | 07-10-2021 | CN 115398034 | A | 25-11-2022 |
| | | | EP 3889319 | A1 | 06-10-2021 |
| | | | EP 4127266 | A1 | 08-02-2023 |
| | | | JP 2023520493 | A | 17-05-2023 |
| | | | US 2023136483 | A1 | 04-05-2023 |
| | | | WO 2021201681 | A1 | 07-10-2021 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20170268100 A
- US 20180171468 A

- WO 2021201681 A